# EUROPEAN PATENT SPECIFICATION

(11) **EP 0 460 605 B1**
(45) Date of publication and mention of the grant of the patent: **08.01.1997**
(21) Application number: 91109110.6
(22) Date of filing: 04.06.1991
(51) Int. Cl.: H01L 29/772

(54) **Thin film transistor and method of manufacturing it**
Dünnfilmtransistor und Verfahren zur Herstellung
Transistor couche mince et sa méthode de fabrication

(30) Priority: 08.06.1990 JP 150151/90
(43) Date of publication of application: 11.12.1991
(73) Proprietor: SEIKO EPSON CORPORATION, Shinjuku-ku Tokyo-to (JP)
(72) Inventor: Inoue, Satoshi, c/o Seiko Epson Corporation, Suwa-shi, Nagano-ken (JP)
(74) Representative: Hoffmann, Eckart, Dipl.-Ing.

(56) References cited:
- EP-A- 0 159 617
- EP-A- 0 190 928
- EP-A- 0 195 607
- EP-A- 0 399 737
- JP-A- 291 973
- US-A- 4 198 250
- US-A- 4 751 196
- PATENT ABSTRACTS OF JAPAN vol. 013, no. 321 (E-790) 20 July 1989, & JP-A- 01 089464
- PATENT ABSTRACTS OF JAPAN vol. 007, no. 226 (E-202) 07 October 1983, & JP-A- 58 115864

## Description

The present invention relates to a thin film transistor which is particularly suitable for use in active matrix type liquid crystal devices, image sensors, three-dimensional integrated circuits or the like.

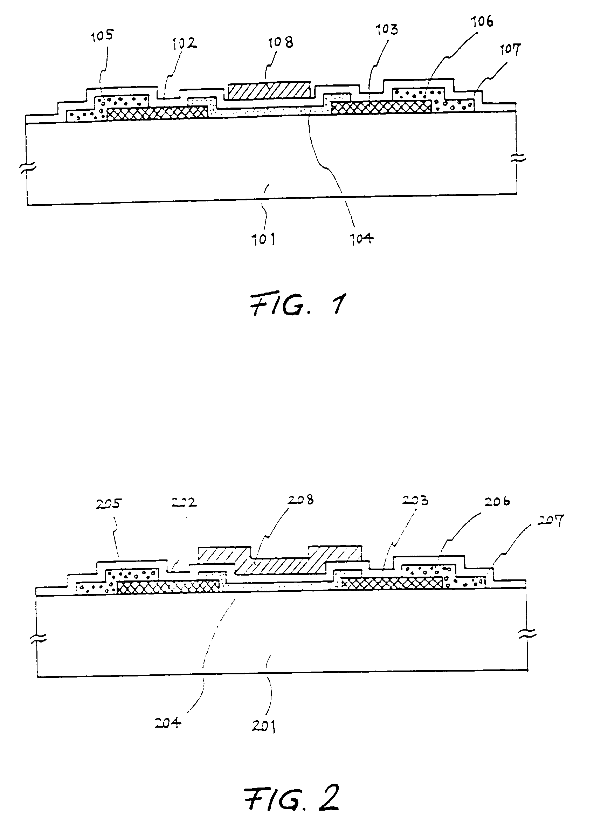

An example of the construction of a conventional thin film transistor will be explained with reference to Fig. 2. Fig. 2 is a cross-sectional view of the construction in the direction of a channel. A source area 202 and a drain area 203, which are composed of a silicon thin film, of such as polycrystalline silicon or amorphous silicon, to which an impurity which serves as a donor or an acceptor is added, are formed on an insulating substrate 201 of glass, quartz, sapphire or the like. A channel area 204 composed of a silicon thin film, of such as polycrystalline silicon or amorphous silicon, is disposed so as to be in contact with the top side of an end of the source area 202 and the top side of an end of the drain area 203 in such a manner as to connect these two areas. A source electrode 205 composed of a metal, a transparent electrically-conductive film, etc. is disposed so as to be in contact with the source area 202, and a drain electrode 206 composed of a metal, a transparent electrically-conductive film, etc. is disposed so as to be in contact with the drain area 203. All of the above is coated with a gate insulation film 207 such as a silicon oxide film, etc. A gate electrode 208 composed of a metal, a transparent electrically-conductive film, etc. is disposed in such a manner as to cover both the source area 202 and the drain area 203, or at least cover a part of each of them. The gate insulation film 207 also serves as an interlayer insulation film for maintaining the insulation among interconnections.

The above-described prior art suffers from the following problems.

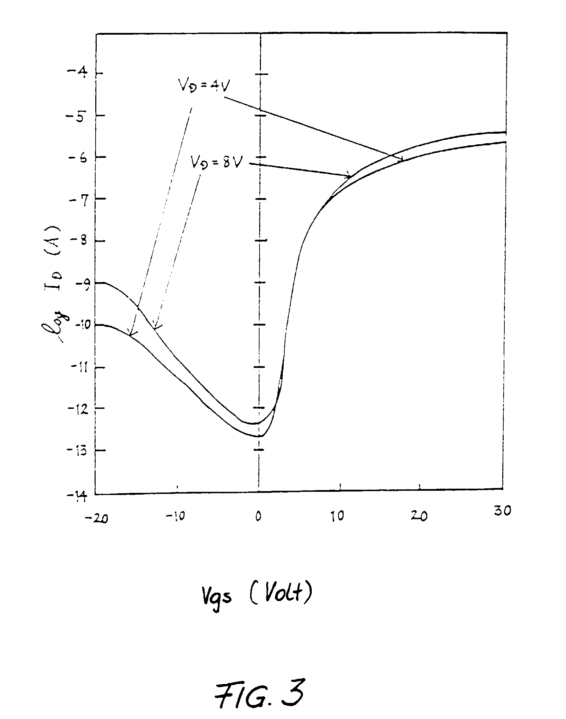

Fig. 3 is a graph showing an example of the characteristics of an N-channel thin film transistor having the construction illustrated in Fig. 2. The horizontal axis indicates the gate voltage Vgs, the vertical line indicates logarithmic values of the drain current Id. In this example, a current that flows between the source and the drain when the transistor is in an OFF-state is denoted as Ioff; a current that flows between the source and the drain when the transistor is in an ON-state is denoted as Ion. A transistor having characteristics such that the ON-current is large and the OFF-current is small, or in other words, characteristics of a high ON/OFF ratio (Ioff/Ion), is preferable. However, generally, if the ON-current is increased, the OFF-current has the tendency to increase also. This fact poses a problem, particularly when an attempt is made to realize an integrated driver type liquid crystal device. That is, it is required that transistors used in the pixel section of a liquid crystal device have characteristics of a low OFF-current, whereas it is required that transistors used in the peripheral circuits have characteristics of a high ON-current in order to allow a high speed operation.

The document JP-A-01 089 464 discloses a thin film transistor of a so-called offset structure wherein the gate electrode is laterally offset from source and drain regions so as not to overlap the source and drain regions. The method of producing this known thin film transistor comprises: forming a semiconductor thin film on a substrate, forming and patterning of a gate insulation layer and a gate electrode on the semiconductor thin film, forming oxide films on both sides of the gate electrode and forming source and drain regions in the semiconductor thin film self-aligned through ion implantation using the gate electrode and the oxide films as a mask.

Another thin film transistor with such offset structure is disclosed in the document US-A-4,751,196.

The document JP-A-02 091 973 discloses a thin film transistor having source/drain regions with increased thickness as compared to the channel region.

The present invention is intended to provide a thin film transistor having characteristics of a high ON/OFF ratio (Ion/Ioff), and a method for manufacturing such a transistor.

This object is achieved with a method for forming thin film transistor as claimed in claim 1. Preferred embodiments of the invention are subject matter of the dependent claims.

These and other objects, features and advantages of the present invention will become clear from the following description of preferred embodiments of the present invention with reference to the accompanying drawings, in which:
- Fig. 1: is a cross-sectional view showing an example of the construction of a thin film transistor as manufactured according to the present invention;
- Fig. 2: is a cross-sectional view showing an example of the construction of a conventional thin film transistor;
- Fig. 3: is a graph showing the characteristics of the conventional thin film transistor;
- Fig. 4: is a graph showing the characteristics of the thin film transistor manufactured according to the present invention; and
- Figs.: 5(a) to 5(c), Figs. 6 (a) to 6(c), Figs. 7(a) to 7(d), Figs. 8(a) to 8(d), Figs. 9(a) to 9(d) and Figs. 10(a) to 10(c) are cross-sectional views showing process steps of embodiments of the manufacturing method according to the present invention.

The second problem is that the number of processes, such as ion implantation, etc., increases greatly.

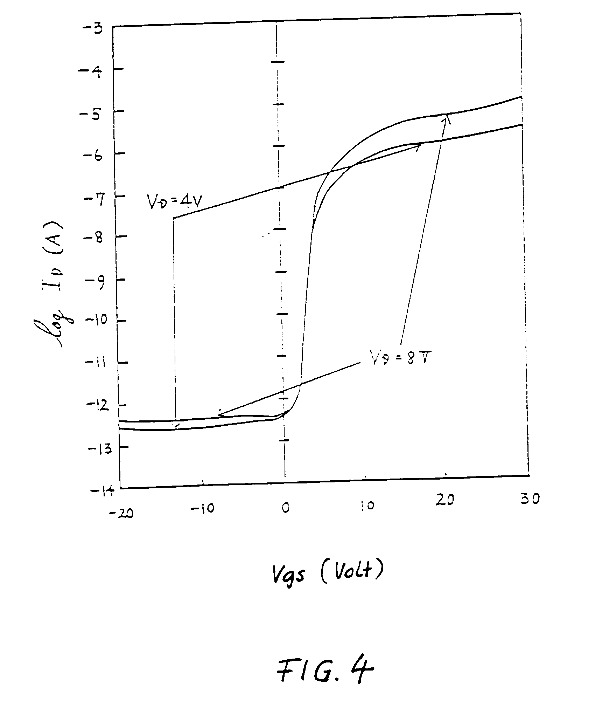

The structure of the thin film transistor of the present invention effectively lowers the voltage between the gate and the drain during off time, since the gate electrode is formed in the so-called offset structure in which the gate electrode does not overlap the source area or the drain area. Also, the crystal structure in an edge portion of the drain is not degraded. Hence, the value of the OFF-current in the vicinity of a gate voltage of 0 V in a conventional transistor can be maintained for gate voltages less than 0 V according to the invention as shown in Fig. 4. The OFF-characteristics of the thin film transistor can be improved greatly. On the other hand, the ON-current is not significantly decreased as compared to a conventional transistor. The reason therefor is that in a thin film transistor, because the silicon layer of the channel section is thin, the range over which a depletion layer extends is limited and an inversion layer is likely to be formed. Therefore, if the length of the offset section is optimized, a decrease in the ON-current can be suppressed. As a result, it has become possible to provide a thin film transistor having excellent characteristics because of a large ON/OFF ratio.

The present invention will be explained in the following.

Fig. 1 is a cross-sectional view showing the construction of a thin film transistor manufactured according to the present invention. A source area 102 and a drain area 103 which are composed of a silicon thin film, of such as polycrystalline silicon or amorphous silicon, to which an impurity which serves as a donor or an acceptor is added, are formed on an insulating substrate 101 of glass, quartz, sapphire or the like. A channel area 104 composed of a silicon thin film, of such as polycrystalline silicon or amorphous silicon, is disposed so as to be in contact with the source area and the drain area in such a manner as to connect these two areas. A source electrode 105 composed of a metal, a transparent electrically-conductive film, etc. is disposed so as to be in contact with the source area 102, and a drain electrode 106 is disposed so as to be in contact with the drain area 103. All of the above is coated with a gate insulation film 107 such as a silicon oxide film, etc. A gate electrode 108 composed of a metal, a transparent electrically-conductive film, etc. is disposed in such a manner as not to cover either the source area 102 or the drain area 103 at the least. The gate insulation film 107 also acts as an interlayer insulation film for maintaining the insulation between interconnections.

### Embodiment 1

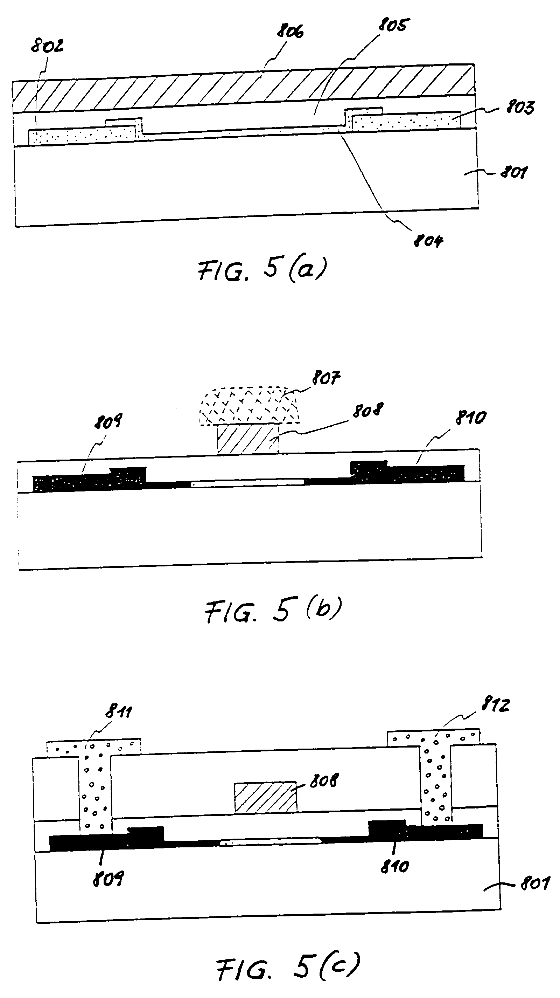

Fig. 5 is a cross-sectional view showing the process steps of an embodiment of the present invention by which a thin film transistor is realized.

Patterns 802 and 803 which are composed of a silicon thin film, of such as polycrystalline silicon or amorphous silicon, are formed on an insulating substrate 801 of glass, quartz, sapphire or the like. A pattern 804 composed of a silicon thin film, of such as polycrystalline silicon or amorphous silicon, is disposed so as to be in contact with the top side of the two areas in such a manner as to connect these two areas. Next, all of the above is coated with a gate insulation film 805 such as a silicon oxide film, etc. Next, formed in turn thereon is an electrically conductive film 806 which serves as o a gate electrode (See Fig. 5(a)). Next, a resist pattern 807 is formed on the electrically conductive film 806 by using a photo etching technique. With this pattern as a mask, the electrically conductive film 806 is selectively etched in such a way that it becomes small relative to the resist pattern, and a gate electrode 808 is formed. By adding an impurity which serves as a donor or an acceptor by ion implantation, a self-aligned source area 809 and a self-aligned drain area 810 are formed. Then, the resist pattern 807 is removed (See Fig. 5(b)).

Thereafter, a source electrode 811 and a drain electrode 812 which are composed of a metal, a transparent electrically-conductive film, etc. are respectively connected to the source area 809 and the drain area 810 according to the usual processes. Thus, a thin film transistor according to the present invention is completed (See Fig. 5(c)).

### Embodiment 2

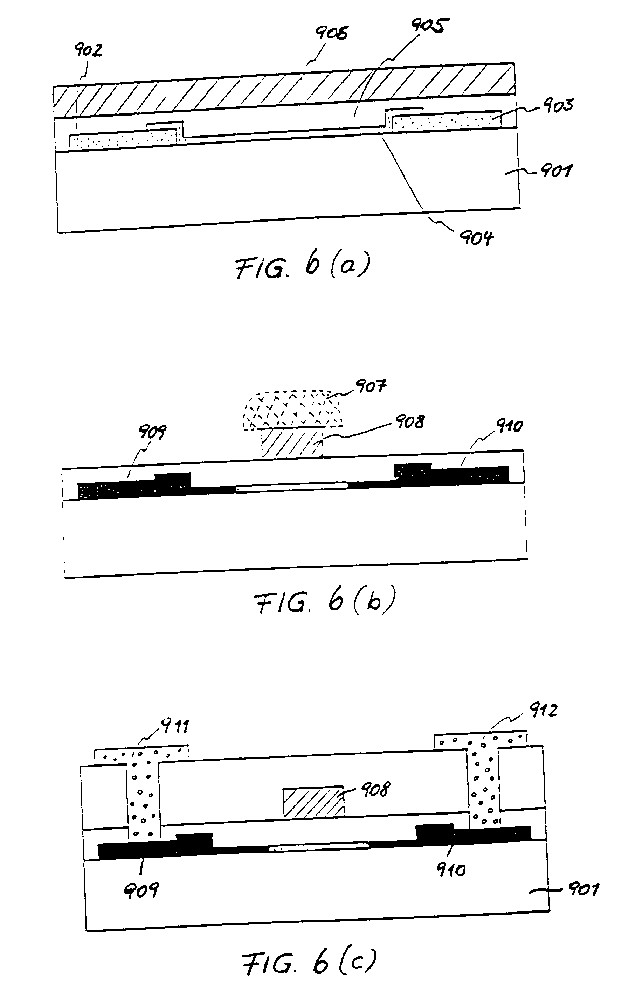

Fig. 6 is a cross-sectional view showing the process steps of another embodiment of the present invention by which a thin film transistor is realized.

Patterns 902 and 903 which are composed of a silicon thin film, of such as polycrystalline silicon or amorphous silicon, are formed on an insulating substrate 901 of glass, quartz, sapphire or the like. A pattern 904 composed of a silicon thin film, of such as polycrystalline silicon or amorphous silicon, is disposed so as to be in contact with the top side of the two areas in such a manner as to connect these two areas. Next, all of the above is coated with a gate insulation film 905 such as a silicon oxide film, etc. Next, formed in turn thereon is an electrically conductive film 906 which serves as a gate electrode (See Fig. 6(a)).

Next, a resist pattern 907 is formed on the electrically conductive film 906 by using a photo etching technique. With this pattern as a mask, the electrically conductive film 906 is selectively etched, and a gate electrode 908 is formed. Then, by adding an impurity which serves as a donor or an acceptor by ion implantation, a self-aligned source area 909 and a self-aligned drain area 910 are formed with respect to the gate electrode. Then, the gate electrode 908 is etched in such a way that it becomes small relative to the resist pattern. Thereafter, the resist pattern 907 is removed (See Fig. 6(b)).

Thereafter, a source electrode 911 and a drain electrode 912 which are composed of a metal, a transparent electrically-conductive film, etc. are respectively connected to the source area 909 and the drain area 910 according to the usual processes. Thus, a thin film transistor according to the present invention is completed (See Fig 6(c)).

### Embodiment 3

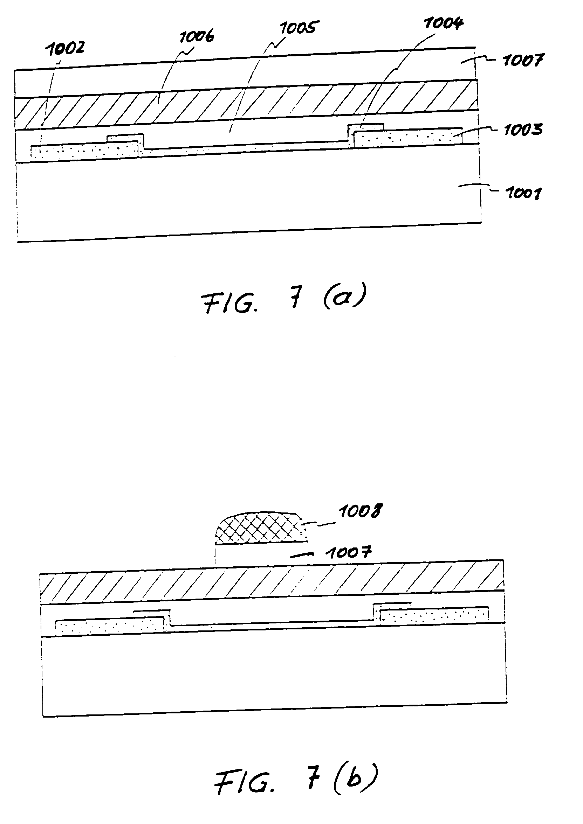

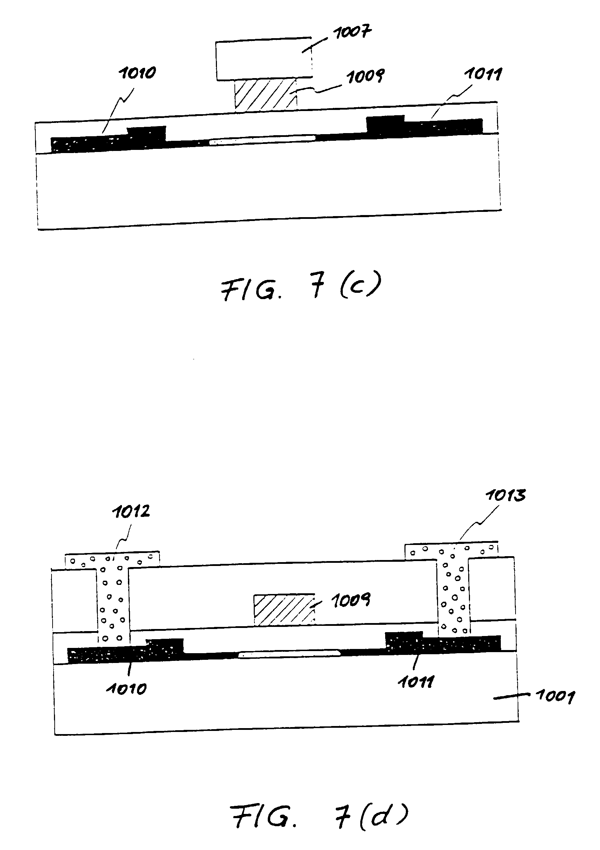

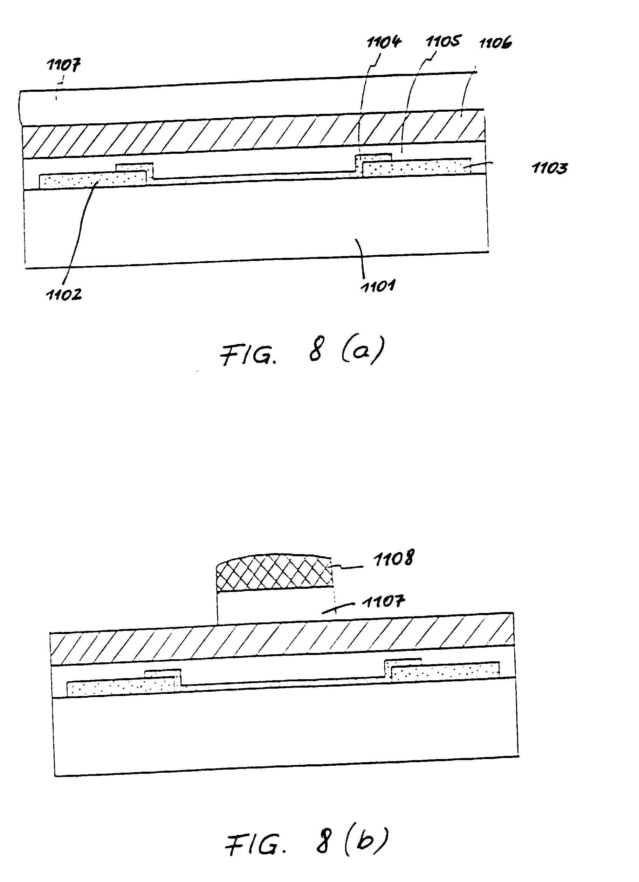

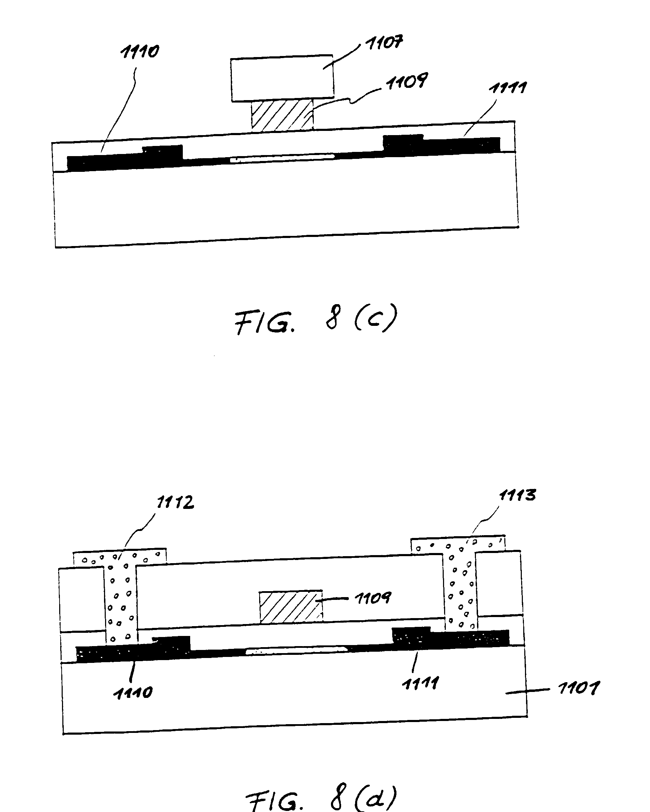

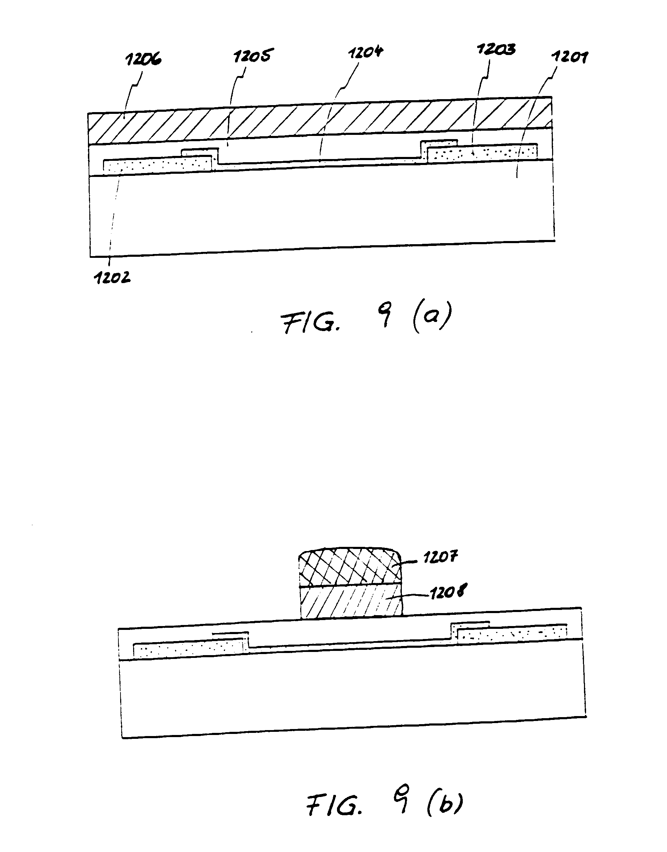

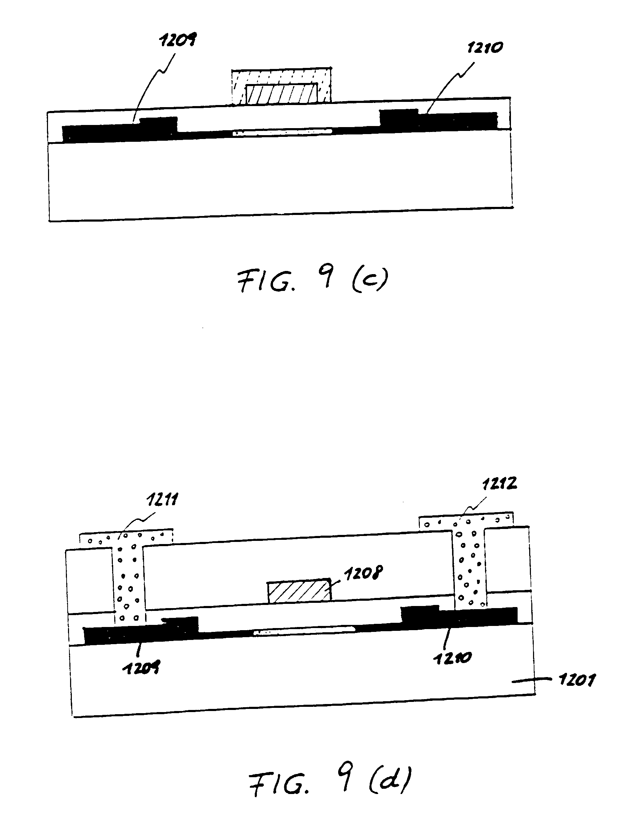

Fig. 7 is a cross-sectional view showing the process steps of another embodiment of the present invention by which a thin film transistor is realized.

Patterns 1002 and 1003 which are composed of a silicon thin film, of such as polycrystalline silicon or amorphous silicon, are formed on an insulating substrate 1001 of glass, quartz, sapphire or the like. A pattern 1004 composed of a silicon thin film, of such as polycrystalline silicon or amorphous silicon, is disposed so as to be in contact with the top side of the two areas in such a manner as to connect these two areas. Next, formed in turn thereon are a gate insulation film 1005 such as a silicon oxide film, etc., an electrically conductive film 1006 which serves as a gate electrode, and a film 1007 such as a silicon oxide film, etc. (See Fig. 7(a)).

Next, a resist pattern 1008 is formed on the silicon oxide film 1007 by using a photo etching technique. With this pattern as a mask, the silicon oxide film 1007 is selectively etched (See Fig. 7(b)).

Thereafter, the resist pattern 1008 is removed. Then, with the silicon oxide film 1007 as a mask, the electrically conductive film 1006 is selectively etched in such a way that it becomes small relative to the silicon oxide film pattern 1007. Thus, a gate electrode 1009 is formed. Then, by adding an impurity which serves as a donor or an acceptor by ion implantation, a source area 1010 and a drain area 1011 are formed in a self-aligned manner with respect to the gate electrode (See Fig. 7(c)).

Thereafter, a source electrode 1012 and a drain electrode 1013 which are composed of a metal, a transparent electrically-conducive film, etc. are respectively connected to the source area 1010 and the drain area 1011 according to the usual processes. Thus, a thin film transistor according to the present invention is completed (See Fig. 7(d)).

### Embodiment 4

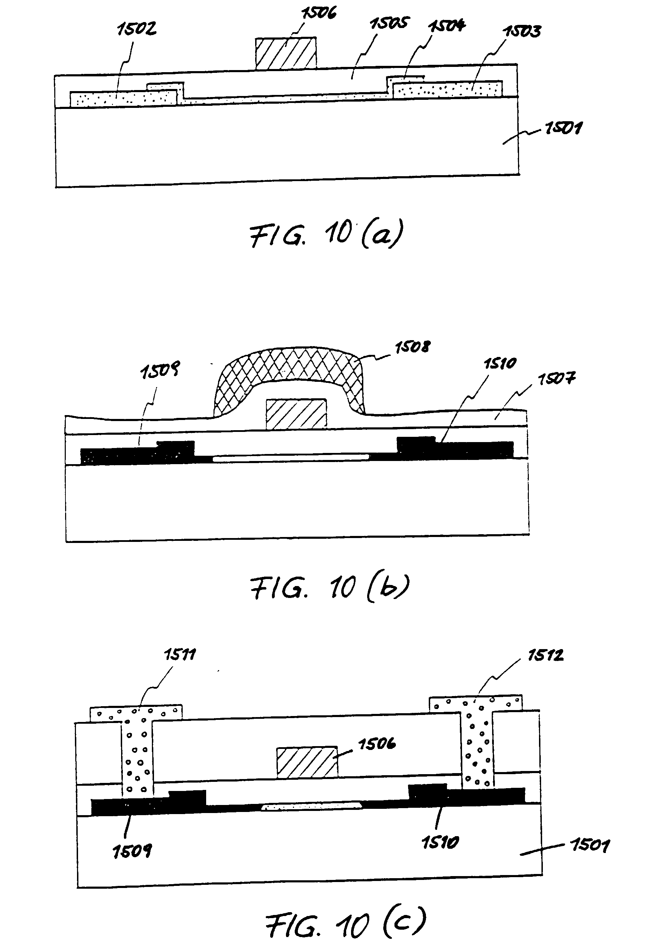

Fig. 8 is a cross-sectional view showing the process steps of another embodiment of the present invention by which a thin film transistor is realized.

Patterns 1102 and 1103 which are composed of a silicon thin film, of such as polycrystalline silicon or amorphous silicon, are formed on an insulating substrate 1101 of glass, quartz, sapphire or the like. A pattern 1104 composed of a silicon thin film, of such as polycrystalline silicon or amorphous silicon, is disposed so as to be in contact with the top side of the two areas in such a manner as to connect these two areas.

Next, formed in turn on all of the above are a gate insulation film 1105 such as a silicon oxide film, etc., an electrically conductive film 1106 which serves as a gate electrode, and a film 1107 such as a silicon oxide film, etc. (See Fig. 8(a)).

Next, a resist pattern 1108 is formed on the silicon oxide film 1107 by using a photo etching technique. With this pattern as a mask, the silicon oxide film 1107 is selectively etched (See Fig. 8(b)).

Thereafter, the resist pattern 1108 is removed. Then, with the silicon oxide film 1107 as a mask, the electrically conductive film 1106 is selectively etched and a gate electrode 1109 is formed. Then, by adding an impurity which serves as a donor or an acceptor by ion implantation, a self-aligned source area 1110 and a self-aligned drain area 1111 are formed. Next, the gate electrode 1109 is selectively etched in such a way that the gate electrode 1109 becomes small relative to the silicon oxide film 1107 (See Fig. 8(c)).

Thereafter, a source electrode 1112 and a drain electrode 1113 which are composed of a metal, a transparent electrically-conductive film, etc. are respectively connected to the source area 1110 and the drain area 1111 according to the usual processes. Thus, a thin film transistor according to the present invention is completed (See Fig. 8(d)).

### Embodiment 5

Fig. 9 is a cross-sectional view showing the process steps of another embodiment of the present invention by which a thin film transistor is realized.

Patterns 1202 and 1203 which are composed of a silicon thin film, of such as polycrystalline silicon or amorphous silicon, are formed on an insulating substrate 1201 of glass, quartz, sapphire or the like. A pattern 1204 composed of a silicon thin film, of such as polycrystalline silicon or amorphous silicon, is disposed so as to be in contact with the top side of the two areas in such a manner as to connect these two areas. Next, formed in turn on all of the above are a gate insulation film 1205 such as a silicon oxide film, etc. and an electrically conductive film 1206 which serves as a gate electrode (See. Fig. 9(a)).

Next, a resist pattern 1207 is formed on the electrically conductive film 1206 by using a photo etching technique. With this pattern as a mask, the electrically conductive film 1206 is selectively etched and a gate electrode 1208 is formed (see Fig. 9(b)).

Then, by adding an impurity which serves as a donor or an acceptor by ion implantation, a self-aligned source area 1209 and a self-aligned drain area 1210 are formed. Next, the gate electrode 1208 is selectively etched so as to be small (See Fig. 9(c)).

Thereafter, a source electrode 1211 and a drain electrode 1212 which are composed of a metal, a transparent electrically-conductive film, etc. are respectively connected to the source area 1209 and the drain area 1210 according to the usual processes. Thus, a thin film transistor according to the present invention is completed (See Fig. 9(d)).

### Embodiment 6

Fig. 10 is a cross-sectional view showing process steps of another embodiment of the present invention by which a thin film transistor is realized.

Patterns 1502 and 1503 which are composed of a silicon thin film, of such as polycrystalline silicon or amorphous silicon, are formed on an insulating substrate 1501 of glass, quartz, sapphire or the like. A pattern 1504 composed of a silicon thin film, of such as polycrystalline silicon or amorphous silicon, is disposed so as to be in contact with the top side of the two areas in such a manner as to connect these two areas. Next, all of the above is coated with a gate insulation film 1505 such as a silicon oxide film, etc. Formed thereon is a gate electrode 1506 composed of a metal, an electrically conductive film, a polycrystalline film to which an impurity is added, etc. (See Fig. 10(a)).

Then, an insulation film 1507, for example, a silicon oxide film, etc. is formed on all of the above. Next, a resist pattern 1508 is formed thereon by using a photo etching technique. With this pattern as a mask, by adding an impurity which serves as a donor or an acceptor to at least a part of each of the patterns 1502 and 1503 by ion implantation, a source area 1509 and a drain area 1510 are formed (See Fig. 10(b)).

Thereafter, the resist pattern 1508 is removed. A source electrode 1511 and a drain electrode 1512 which are composed of a metal, a transparent electrically-conductive film, etc. are respectively connected to the source area 1509 and the drain area 1510 according to the usual processes. Thus, a thin film transistor according to the present invention is completed (See Fig. 10(c)).

In the above, embodiments for realizing the present invention have been explained. The present invention can be realized by using materials other than those mentioned above. As has been explained above, with the thin film transistor manufactured according to the present invention, it is possible to reduce the OFF-current dramatically without reducing the ON-current. This thin film transistor is a breakthrough invention which paves the way particularly for an integrated driver built-in a large type liquid crystal display. In addition, a considerable improvement in the performance of the display and a reduction in costs thereof can be expected when a conventional thin film transistor is replaced with the thin film transistor of the present invention. For example, in a conventional liquid crystal display, since the OFF-current of a thin film transistor used in the pixel section thereof is large, transistors are connected in series in order to reduce the OFF-current. However, the above does not have to be done if the thin film transistor of the present invention is used and therefore the yield and the picture quality of the display can be enhanced.

As set forth herein above, the present invention can be used for all applications for which thin film transistors are used, such as image sensors, liquid crystal displays, etc. The present invention makes a great contribution toward improving the performance of the above devices and reducing the costs thereof.

## Claims

1. A method of manufacturing a thin film transistor, comprising the steps of:
(a) forming a first silicon thin film on an insulating substrate (801; 901;1001;1101 1201);
(b) forming two separated thin film patterns (802, 803; 902, 903; 1002, 1003; 1102, 1103; 1202, 1203) by selectively etching the first silicon thin film;
(c) forming on the substrate between and partly on said first and second thin film patterns a second silicon thin film (804; 904; 1004; 1104; 1204);
(d) forming a gate insulation film (805; 905; 1005; 1105; 1205) and an electrically conductive film (806; 906; 1006; 1106; 1206) on said two thin film patterns and said second silicon thin film;
(f) forming a source area and a drain area (809, 810; 909, 910; 1009, 1010; 1109, 1110; 1209, 1210) in a self-aligned manner by implanting impurities into said first and second thin film patterns and adjacent portions of said second silicon thin film using a mask (807; 907; 1007; 1107; 1206) having a lateral dimension larger than that of a gate electrode (808; 908; 1009; 1109; 1208); and
(g) forming said gate electrode by selectively etching said electrically conductive film.

2. The method of claim 1 wherein said mask (807; 907, 906; 1007; 1107, 1106) is formed on said electrically conductive film and step (g) is performed before or after step (f).

3. The method of claim 1 wherein said electrically conductive film (1206) is used as the implantation mask and step (g) is performed after step (f).

## Patentansprüche

1. Verfahren zur Herstellung eines Dünnschichttransistors, das folgende Schritte umfaßt:
(a) Bilden einer ersten Siliziumdünnschicht auf einem Isoliersubstrat (801; 901; 1001; 1101; 1201);
(b) Bilden zweier getrennter Dünnschichtmuster (802, 803; 902, 903; 1002, 1003; 1102, 1103; 1202, 1203) durch selektives Ätzen der ersten Siliziumdünnschicht;
(c) Bilden einer zweiten Siliziumdünnschicht (804; 904; 1004; 1104; 1204) auf dem Substrat zwischen und teilweise auf dem ersten sowie dem zweiten Dünnschichtmuster;
(d) Bilden einer Gate-lsolierschicht (805; 905; 1005; 1105; 1205) und einer elektrisch leitenden Schicht (806; 906; 1006; 1106; 1206) auf den zwei Dünnschichtmustern und der zweiten Siliziumdünnschicht;
(f) Bilden eines Source-Bereichs und eines Drain-Bereichs (809, 810; 909, 910; 1009, 1010; 1109, 1110; 1209, 1210) in selbstjustierender Weise durch Implantieren von Verunreinigungen in das erste und das zweite Dünnschichtmuster und benachbarte Abschnitte der zweiten Siliziumdünnschicht unter Verwendung einer Maske (807; 907; 1007; 1107; 1206) mit einer Querabmessung, die größer als diejenige einer Gate-Elektrode (808; 908; 1009; 1109; 1208) ist; und
(g) Bilden der Gate-Elektrode durch selektives Ätzen der elektrisch leitenden Schicht.

2. Verfahren nach Anspruch 1, bei dem die Maske (807; 907, 906; 1007; 1107, 1106) auf der elektrisch leitenden Schicht gebildet und Schritt (g) vor oder nach Schritt (f) ausgeführt wird.

3. Verfahren nach Anspruch 1, bei dem die elektrisch leitende Schicht (1206) als Implantationsmaske verwendet und Schritt (g) nach Schritt (f) ausgeführt wird.

## Revendications

1. Procédé de fabrication d'un transistor en couche mince, comprenant les étapes de :
(a) formation d'une première couche mince de silicium sur un substrat isolant (801 ; 901 ; 1001 ; 1101 ; 1201) ;
(b) formation de deux motifs séparés à couche mince (802, 803 ; 902, 903 ; 1002, 1003 ; 1102, 1103 ; 1202, 1203) en gravant de façon sélective la première couche mince de silicium ;
(c) formation sur le substrat entre et partiellement sur les premier et deuxième motifs à couche mince d'une deuxième couche mince de silicium (804 ; 904 ; 1004 ; 1104 ; 1204) ;
(d) formation d'une couche (805 ;905 ; 1005 ; 1105 ; 1205) isolante de grille et d'une couche électriquement conductrice (806 ; 906 ; 1006 ; 1106 ; 1206) sur les deux motifs à couche mince et la deuxième couche mince de silicium ;
(f) formation d'une zone de source et d'une zone du drain (809, 810 ; 909, 910 ; 1009, 1010 ; 1109, 1110 ; 1209, 1210) d'une manière alignée automatiquement en implantant des impuretés dans les premier et deuxième motifs à couche mince et dans des parties adjacentes de la deuxième couche mince de silicium, en utilisant un masque (807 ; 907 ; 1007 ; 1107 ; 1206) ayant une dimension latérale supérieure à celle d'une électrode de grille (808 ; 908 ; 1009 ; 1109 ; 1208) ; et
(g) formation de l'électrode de grille en gravant de façon sélective la couche électriquement conductrice.

2. Procédé suivant la revendication 1 dans lequel le masque (807 ; 907 ; 1007 ; 1107, 1106) est formé sur la couche électriquement conductrice et l'étape (g) est réalisée avant ou après l'étape (f).

3. Procédé suivant la revendication 1 dans lequel la couche électriquement conductrice (1206) est utilisée comme masque d'implantation et l'étape (g) est réalisée après l'étape (f).
